# EUROPÄISCHE PATENTSCHRIFT

(11) **EP 1 436 840 B1**
(45) Veröffentlichungstag und Bekanntmachung des Hinweises auf die Patenterteilung: **21.12.2005**
(21) Anmeldenummer: 02774544.7
(22) Anmeldetag: 30.08.2002
(51) Int. Cl.: H01L 27/082

(54) **HALBLEITERSTRUKTUR MIT VERRINGERTER KAPAZITIVER KOPPLUNG ZWISCHEN BAUELEMENT**
SEMICONDUCTOR STRUCTURE WITH REDUCED CAPACITIVE COUPLING BETWEEN COMPONENTS
STRUCTURE A SEMI-CONDUCTEUR A COUPLAGE CAPACITIF REDUIT ENTRE DES COMPOSANTS

(30) Priorität: 17.10.2001 DE 10151203
(43) Veröffentlichungstag der Anmeldung: 14.07.2004
(73) Patentinhaber: Infineon Technologies AG, 81669 München (DE)
(72) Erfinder: BOECK, Josef, 81827 München (DE); MEISTER, Thomas, 82024 Taufkirchen (DE); SCHAEFER, Herbert, 85635 Höhenkirchen-Siegertsbrunn (DE); STENGL, Reinhard, 86391 Stadtbergen (DE)
(74) Vertreter: Stöckeler, Ferdinand
(86) Internationale Anmeldenummer: PCT/EP2002/009703
(87) Internationale Veröffentlichungsnummer: WO 2003/036724

(56) Entgegenhaltungen:
- FR-A- 2 779 869
- US-A- 5 371 401
- US-A- 5 624 854
- US-A- 5 892 264
- US-A- 5 994 759
- US-A- 6 130 458
- US-A1- 2001 008 284
- BURGHARTZ J N ET AL: "A LOW-CAPACITANCE BIPOLAR/BICMOS ISOLATION TECHNOLOGY, PART 1- CONCEPT, FABRICATION PROCESS, AND CHARACTERIZATION" IEEE TRANSACTIONS ON ELECTRON DEVICES, IEEE INC. NEW YORK, US, Bd. 41, Nr. 8, 1. August 1994 (1994-08-01), Seiten 1379-1386, XP000483758 ISSN: 0018-9383

## Beschreibung

Die vorliegende Erfindung bezieht sich auf eine Halbleiterstruktur mit einem Bipolar-Transistor und insbesondere auf eine Halbleiterstruktur mit einem Bipolar-Transistor, der von einem Halbleiter-Bauelement kapazitiv entkoppelt ist.

Die zunehmend höhere Integrationsdichte von Halbleiter-Bauelementen in Halbleiter-Chips hat unter anderem zur Folge, daß die Halbleiter-Bauelemente zunehmend kleiner Abstände voneinander aufweisen. Je kleiner der Abstand zwischen zwei Halbleiter-Bauelementen ist, desto größer ist die kapazitive Kopplung und damit das elektrische Übersprechen zwischen den Halbleiter-Bauelementen. Die kapazitive Kopplung kann dabei direkt innerhalb der Bauelementschicht des Chips und indirekt über das darunterliegende Substrat, das in der Regel eine elektrische Leitfähigkeit aufweist, erfolgen. Bei einer SOI-Struktur (SOI = Silicon On Insulator = Silizium auf Isolator) ist die (Silizium-)Bauelementschicht durch eine Isolierschicht, die meist durch eine vergrabene Oxidschicht gebildet wird, von dem Substrat elektrisch isoliert. Die vergrabene Oxidschicht wird auch als BOX (BOX = buried oxide) bezeichnet. Wenn das Bauelemente eine integrierte Spule ist, wird deren elektrische Güte durch eine kapazitive Kopplung an ein anderes Bauelement beeinflußt bzw. verschlechtert. Im Fall integrierter Hochfrequenz-Schaltungen wird ferner durch die kapazitive Kopplung zwischen einzelnen Bauelementen eines Chips sowie zwischen einem Bauelemente und Halbleitermaterial, das nicht Bestandteil eines Bauelements ist, die Verlustleistung erhöht.

Eine Anforderung bei Entwurf und Konstruktion von Halbleiterstrukturen ist deshalb eine möglichst weitgehende Verringerung der kapazitiven Kopplung zwischen den einzelnen Bauelementen. Eine weitere Anforderung ist eine möglichst wirkungsvolle Abführung von Verlustleistung der Bauelemente der Halbleiterstruktur. Beide Anforderungen stehen einander teilweise entgegen, da bei vielen Materialien, beispielsweise bei dem in der Halbleitertechnologie oft zur elektrischen Isolation verwendeten Oxid, gute elektrische Isolationseigenschaften mit einer schlechten Wärmeleitfähigkeit einhergehen.

Bisherige Lösungen zur Erfüllung dieser Anforderungen sind als Full-Trench- und Partial-Trench-Isolation in SOI-Strukturen für CMOS-Bauelemente (CMOS = complementary metal oxide semiconductor) bekannt. Beispiele werden in dem Artikel "Impact of 0.18 µm SOI CMOS Technology using Hybrid Trench Isolation with High Resistivity Substrate on Embedded RF/Analog Applications" von S. Maeda et al., 2000 Symposium on VLSI Technology - Digest of Technical Papers (Cat. No00CH37104), S. 154-155, und in dem Artikel "Impact of 0.10 µm SOI CMOS with Body-Tied Hybrid Trench Isolation Structure to Break Through the Scaling Crisis of Silicon Technology" von Y. Hirano et al., IEDM 2000, Technical Digest (Cat.Nr.00CH37138), S. 467-470, beschrieben.

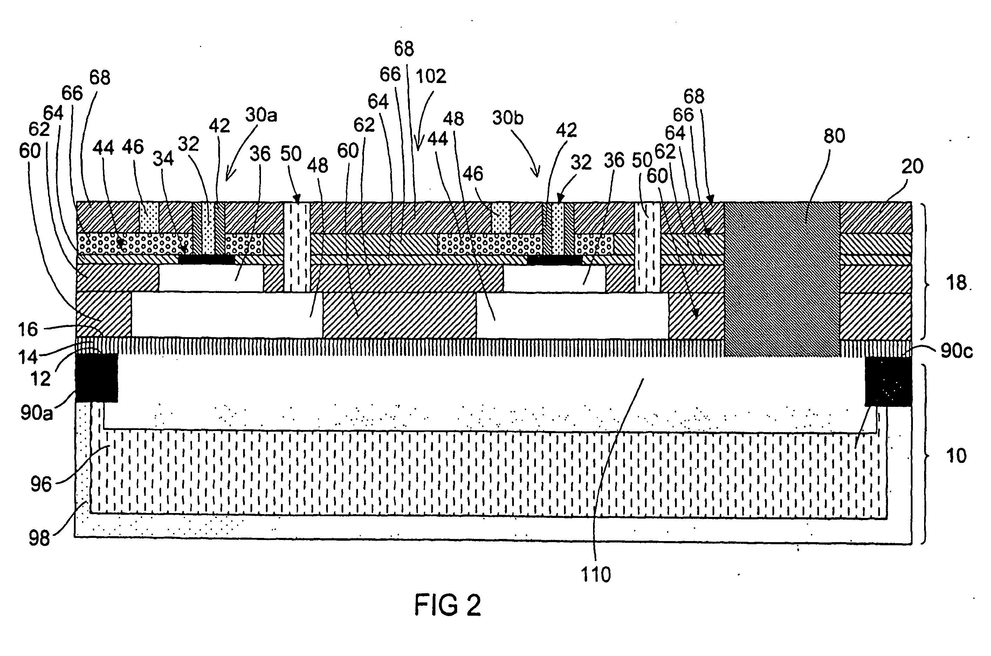

Ein Trench bzw. ein Graben ist in diesem Zusammenhang ein Graben in einer Bauelementschicht, der vorzugsweise mit einem elektrisch isolierenden Material gefüllt ist, zur Isolation zweier lateral benachbarter Bereiche in der Bauelementschicht. Ein partial bzw. shallow trench bzw. ein flacher Graben ist ein Graben, der nicht bis zu der vergrabenen Oxidschicht der SOI-Struktur reicht, bei dem also zwischen dem Graben und der vergrabenen Oxidschicht Silizium verbleibt. Eine durch einen flachen Graben bewirkte STI (STI = Shallow Trench Isolation) ist somit einer Isolation durch Gräben auf einem normalen Bulk- bzw. Volumen-Wafer ohne SOI-Struktur ähnlich, bei der ein Strompfad zwischen zwei durch den Graben getrennten Bauelementen in dem Wafer eingeschnürt und verlängert, jedoch nicht vollständig unterbrochen wird. Der Artikel "A 73 GHz f_{T} 0.18 µm RF-SiGe BiCMOS Technology considering Thermal Budget Trade-off and with reduced Boron-spike Effekt on HBT Characteristics" von T. Hashimoto et al., IEDM 2000, Technical Digest (Cat. No. 00CH37138), S. 149-152) zeigt in Fig. 2 einen Querschnitt eines Beispieles für eine solche Isolation für den Fall eines BiCMOS-Prozesses bzw. -Chips (BiCMOS = Bipolar-CMOS = Kombination von Bipolar- und CMOS-Technologie). Der Partial Trench ist durch eine vergleichsweise geringe Ätztiefe gekennzeichnet, die im Bereich der minimalen lateralen Lithographieauflösung liegt, beispielsweise beträgt die Tiefe eines Partial Trench im Fall eines 0,25 µm-CMOS-Prozesses typischerweise 0,3 µm.

Ein Full Trench bzw. ein vollständiger Graben ist ein Graben zwischen Bauelementen eines Chips mit SOI-Struktur, bei dem das Silizium bis zu der vergrabenen Oxid- bzw. IsolatorSchicht geätzt bzw. unterbrochen ist, so daß Strompfade zwischen den Bauelementen vollständig unterbrochen sind. Ein Full Trench kann größere Transistorbereiche voneinander trennen, wie es auch in dem oben genannten Artikel von S. Maeda beschrieben ist. Ober einem Full Trench können größere passive Bauelemente angeordnet sein.

Ein Deep Trench bzw. ein tiefer Graben wird beispielsweise in dem Artikel "An SOI-Based High Performance Self-Aligned Bipolar Technology Featuring 20 ps Gate-Delay and a 8.6 fJ Power-Delay Product" von E. Bertagnolli et al., 1993 Symposium on VLSI Technology, Digest of Technical Papers (Cat. Nr.: 93CH3303-5) S. 63-64) beschrieben. In diesem Artikel wird ein Bipolar-Prozeß auf SOI vorgestellt, in dem ein Bipolar-Transistor durch einen tiefen Graben isoliert wird, der bis zu der vergrabenen Oxidschicht der SOI-Struktur reicht und ein Tiefe-zu-Breite-Verhältnis > 1 aufweist. Im Gegensatz zum Full Trench ist der Deep Trench nicht breit genug, um darüber passive Bauelemente in ihren vollen Abmessungen integrieren zu können. Vielmehr dient der Deep Trench ausschließlich zur dielektrischen Bauelementisolation. Das Prinzip des Deep Trench bzw. der Isolation mit einem Deep Trench ist in dem Artikel "Process yields 50-MHZ op amp." von J. H. Day, Electronic Engineering Times, 2. April 2001, dargestellt.

Im folgenden wird zwischen einem vollständigen Graben und einem tiefen Graben nicht mehr unterschieden, und alle Gräben, die bis zu der vergrabenen Oxidschicht reichen, werden als tiefe Gräben bezeichnet.

Zur kapazitiven Entkopplung eines Halbleiter-Bauelements in einer Halbleiterstruktur von einem darunterliegenden Substrat wird herkömmlich eine dicke Isolierschicht, die in der Regel mindestens ca. 1 µm dick ist und aus einem Oxid besteht, verwendet. Da das Oxid eine sehr schlechte spezifische Wärmeleitfähigkeit aufweist, behindert die dicke Isolierschicht die Wärmeableitung von Bauelementen in das Substrat und somit die Abfuhr von Verlustleistung. Dieser Nachteil ist um so schwerwiegender, je größer die Integrationsdichte von Bauelementen in der Halbleiterstruktur ist und je schneller die Halbleiterstruktur getaktet ist.

Ein Nachteil des oben beschriebenen Standes der Technik besteht darin, daß eine kapazitive Kopplung zwischen zwei Bauelementen in einer Halbleiterstruktur nur teilweise und unvollständig reduziert wird. Für viele Anwendungen ist jedoch eine weitere Reduzierung des Übersprechens zwischen einzelnen Bauelementen einer Halbleiterstruktur wünschenswert. Dies gilt insbesondere für Halbleiterstrukturen, die einen Bipolar-Transistor aufweisen. Ferner treten bei Hochfrequenz-Schaltungen mit Bipolar-Transistoren gemäß dem Stand der Technik hohe Verlustleistungen auf.

Aus der US 2001/0008284 A1 ist eine integrierte Schaltung mit CMOS-Transistoren auf einem SOI-Substrat bekannt, welche ferner Bipolar-Transistoren hat, die in einer Epitaxieschicht ausgebildet sind. Von zwei benachbarten vertikalen Biopolar-Transistoren ist einer im Substratmaterial ausgebildet, während der andere vom Substratmaterial durch eine vergrabene Oxidschicht getrennt ist. Zwischen zwei benachbarten vertikalen Bipolar-Transistoren liegen CMOS-Transistoren.

Aus der US 5,892,264 A sind integrierte Schaltungen mit jeweils einem PNP-Bipolar-Transistor und einem NPN-Bipolar-Transistor bekannt, die auf vergrabenen Isolierschichten angeordnet sind. In lateraler Richtung sind die lateralen Bipolar-Transistoren durch isolierende Trenches voneinander entkoppelt. Der Bereich zwischen den Trenches besteht aus Polysilizium.

Aus der US 6,130,458 A sind vollständig voneinander isolierte Bauelemente bekannt.

Die Aufgabe der vorliegenden Erfindung besteht darin, eine Halbleiterstruktur mit vertikalen Bipolar-Transistoren zu schaffen, bei der eine weitgehende kapazitive Entkopplung der Bipolar-Transistoren voneinander erreicht wird.

Diese Aufgabe wird durch eine Halbleiterstruktur gemäß Anspruch 1 gelöst.

Weitere bevorzugte Weiterbildungen der vorliegenden Erfindung sind in den Unteransprüchen definiert.

Der vorliegenden Erfindung liegt die Erkenntnis zugrunde, daß die kapazitive Kopplung und damit ein Übersprechen zwischen einem Bipolar-Transistor und einem Halbleiter-Bauelement in einer Halbleiterstruktur sowie im Fall einer Hochfrequenzanwendung die verlustleistung verringert werden können, wenn ein Zwischenraum zwischen dem Bipolar-Transistor und dem Halbleiter-Bauelement möglichst wenig Halbleitermaterial enthält und statt dessen möglichst vollständig mit elektrisch isolierendem Material gefüllt ist.

Ein Vorteil der vorliegenden Erfindung besteht darin, daß die kapazitive Kopplung zwischen dem Bipolar-Transistor und dem Halbleiter-Bauelement und damit ein Übersprechen zwischen denselben verringert wird. Ein weiterer Vorteil der vorliegenden Erfindung besteht darin, daß in Hochfrequenzanwendungen die Verlustleistung gegenüber Halbleiterstrukturen gemäß dem Stand der Technik verringert wird. Beide Vorteile gehen dabei nicht zu Lasten der Integrationsdichte bzw. des Verhältnisses der Anzahl von Bauelementen zu der durch sie eingenommenen Chipfläche. Ein weiterer Vorteil der vorliegenden Erfindung besteht darin, daß sie mit Standardtechnologien kompatibel ist und insbesondere in herkömmliche Herstellungsverfahren integrierbar ist und keine zusätzlichen Herstellungsprozeßschritte erfordert.

Nachfolgend werden bevorzugte Ausführungsbeispiele der vorliegenden Erfindung anhand der beiliegenden Figuren näher erläutert. Es zeigen:
Fig. 1 eine schematische Schnittdarstellung eines bevorzugten Ausführungsbeispieles der vorliegenden Erfindung;
Fig. 2 eine schematische Schnittdarstellung eines weiteren bevorzugten Ausführungsbeispieles der vorliegenden Erfindung;
Fig. 3a bis 3c verschiedene Varianten eines Details des in Fig. 2 dargestellten Ausführungsbeispieles;
Fig. 4 ein Diagramm, das schematisch für zwei verschiedene Substratdotierungen einen Zusammenhang zwischen einer an einem Substratkontakt anzulegenden Spannung und einer Dotierungs-Implantierungsdosis zeigt;
Fig. 5 eine schematische Schnittdarstellung der in Fig. 1 dargestellten Halbleiterstruktur in einer ersten Phase während eines Herstellungsverfahrens gemäß einem Ausführungsbeispiel der vorliegenden Erfindung;
Fig. 6 eine schematische Schnittdarstellung der Halbleiterstruktur aus Fig. 1 in einer zweiten Phase des Herstellungsverfahrens von Fig. 5;
Fig. 7 eine schematische Schnittdarstellung der Halbleiterstruktur aus Fig. 1 in einer dritten Phase des Herstellungsverfahrens aus Fig. 5;
Fig. 8 eine schematische Schnittdarstellung der Halbleiterstruktur aus Fig. 1 in einer ersten Phase eines Herstellungsverfahrens gemäß einem weiteren Ausführungsbeispiel der vorliegenden Erfindung;
Fig. 9 eine schematische Schnittdarstellung der Halbleiterstruktur aus Fig. 1 in einer zweiten Phase des Herstellungsverfahrens aus Fig. 8; und
Fig. 10 eine schematische Schnittdarstellung der Halbleiterstruktur aus Fig. 1 in einer dritten Phase des Herstellungsverfahrens aus Fig. 8.

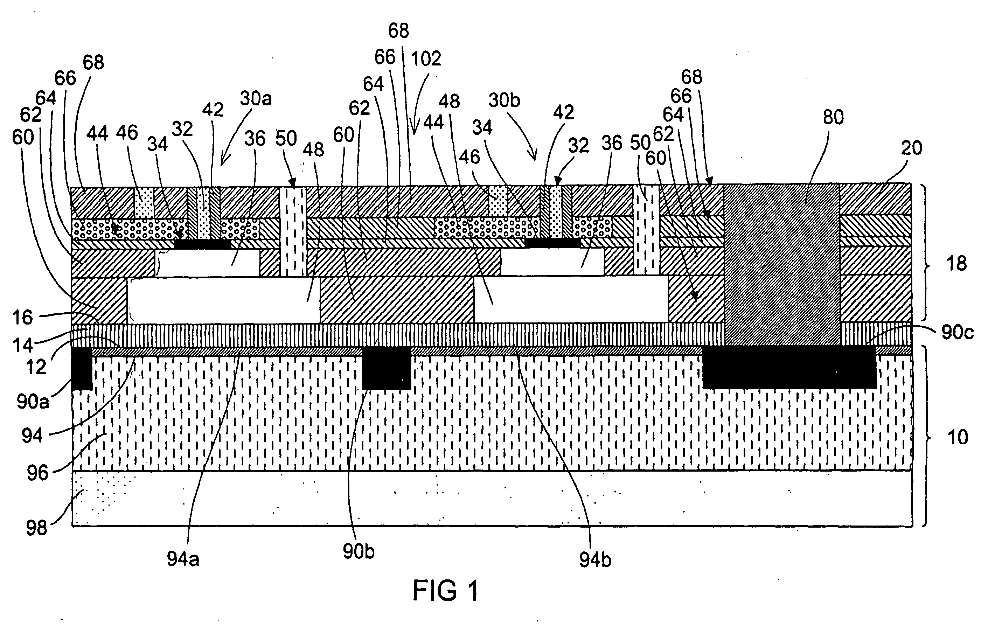

Fig. 1 ist eine schematische Darstellung eines Schnitts durch eine Halbleiterstruktur gemäß einem Ausführungsbeispiel der vorliegenden Erfindung, wobei der Schnitt senkrecht zu Schichten der Halbleiterstruktur angeordnet ist. Die Halbleiterstruktur umfaßt ein Substrat 10 mit einer Oberfläche 12, an der eine Isolierschicht 14 angeordnet ist. An einer von dem Substrat abgewandten Oberfläche 16 der Isolierschicht 14 ist eine Bauelementschicht 18 mit einer von der Isolierschicht 14 abgewandten Oberfläche 20 angeordnet, in der wiederum ein erster Bipolar-Transistor 30a und ein zweiter Bipolar-Transistor 30b angeordnet sind. Der erste Bipolar-Transistor 30a und der zweite Bipolar-Transistor 30b weisen jeweils einen Emitter 32, eine Basis 34 und einen Kollektor 36 auf.

Im folgenden wird nur der erste Bipolar-Transistor 30a beschrieben, der zweite Bipolar-Transistor 30b ist in diesem Ausführungsbeipiel gleich zu dem ersten Bipolar-Transistor 30a aufgebaut.

Der Emitter 32 grenzt an die Basis 34 und liegt an der Oberfläche 20 der Bauelementschicht 18 offen, so daß er für eine elektrische Kontaktierung zugänglich ist. Gegenüber anderen Bereichen der Halbleiterstruktur ist der Emitter 32 durch einen Spacer bzw. eine Emitterisolierschicht 42 elektrisch isoliert, die ihn im wesentlichen zylindrisch umgibt. Die Basis 34 grenzt ferner an den Kollektor 36 und einen ersten Basiskontaktierbereich 44. Ein zweiter Basiskontaktierbereich 46 erstreckt sich von der Oberfläche 20 der Bauelementschicht 18 bis zu dem ersten Basiskontaktierbereich 44. Der Kollektor 36 grenzt ferner an einen ersten Kollektorkontaktierbereich 48, der durch eine vergrabene Schicht des Bipolar-Transistors gebildet wird. Ein zweiter Kollektorkontaktierbereich 50 erstreckt sich von der Oberfläche 20 der Bauelementschicht 18 bis zu dem ersten Kollektorkontaktierbereich 48.

Der erste und der zweite Bipolar-Transistor 30a, 30b sind durch elektrisch isolierendes Material wie folgt voneinander und nach außen elektrisch isoliert. Eine erste Bauelement-Isolierschicht 60 grenzt an die Isolierschicht 14 und in lateraler Richtung an die ersten Kollektorkontaktierbereiche 48. Eine zweite Bauelement-Isolierschicht 62 grenzt an die erste Bauelement-Isolierschicht 60, die ersten Kollektorkontaktierbereiche 48, d. h. die vergrabene Schicht, und lateral an die zweiten Kollektorkontaktierbereiche 50 und die Kollektoren 36. Eine dritte Bauelement-Isolierschicht 64 grenzt an die zweite Bauelement-Isolierschicht 62, die Kollektoren 36 und lateral an die Basen 34 und die zweiten Kollektorkontaktierbereiche 50. Eine vierte Bauelement-Isolierschicht 66 grenzt an die dritte Bauelement-Isolierschicht 64 und lateral an die ersten Basiskontaktierbereiche 44 und die zweiten Kollektorkontaktierbereiche 50. Eine fünfte Bauelement-Isolierschicht 68 grenzt an die vierte Bauelement-Isolierschicht 66, die ersten Basiskontaktierbereiche 44 und lateral an die zweiten Basiskontaktierbereiche 46, die Emitterisolierschichten 42 und die zweiten Kollektorkontaktierbereiche 50.

Ein Substratkontaktierbereich 80 reicht von der Oberfläche 20 der Bauelementschicht 18 durch alle Bauelement-Isolierschichten 60 bis 68 und die Isolierschicht 14 bis in das Substrat 10 und ist von den Bipolar-Transistoren 30a, 30b lateral beabstandet.

Die Emitter 32, die Basen 34, die Kollektoren 36, die Basiskontaktierbereiche 44, 46 und die Kollektorkontaktierbereiche 48, 50 weisen dotiertes und damit elektrisch leitfähiges monokristallines oder polykristallines Silizium auf. Dabei seien bei diesem Ausführungsbeispiel die Emitter 32 und die Kollektoren 36 n-dotiert, die Basen 34 p-dotiert und die Bipolar-Transistoren 30a, 30b somit npn-Transistoren.

Die Isolierschicht 14, die Emitterisolierschichten 42 und die Bauelement-Isolierschichten 60-68 weisen eines oder mehrere elektrisch isolierende Materialien auf, beispielsweise ein Siliziumoxid oder eine Siliziumnitrid und bewirken eine galvanische bzw. dielektrische bzw. elektrostatische Isolation. Die Emitterisolierschichten 42 umschließen die Emitter 32 in lateraler Richtung vollständig und isolieren sie so gegenüber dem jeweils benachbarten ersten Basiskontaktierbereich 44. Die ersten Kollektorkontaktierbereiche 48 und der Substratkontaktierbereich 80 grenzen jeweils in lateraler Richtung entlang ihres gesamten Umfanges bzw. Außenrandes an die erste Bauelement-Isolierschicht 60. Die Kollektoren 36, die zweiten Kollektorkontaktierbereiche 50 und der Substratkontaktierbereich 80 grenzen in lateraler Richtung jeweils entlang ihres gesamten Umfanges an die zweite Bauelement-Isolierschicht 66. Die Basen 34, die zweiten Kollektorkontaktierbereiche 50 und der Substratkontaktierbereich 80 grenzen in lateraler Richtung jeweils entlang ihres gesamten Umfanges an die dritte Bauelement-Isolierschicht 64. Die ersten Basiskontaktierbereiche 44, die zweiten Kollektorkontaktierbereiche 50 und der Substratkontaktierbereich 80 grenzen in lateraler Richtung jeweils entlang ihres gesamten Umfanges an die vierte Bauelement-Isolierschicht 66. Die zweiten Basiskontaktierbereiche 46, die zweiten Kollektorkontaktierbereiche 50 und der Substratkontaktierbereich 80 grenzen in lateraler Richtung jeweils entlang ihres gesamten Umfanges an die fünfte Bauelement-Isolierschicht 68.

Anders ausgedrückt sind insbesondere die Kollektoren 36 der Bipolar-Transistoren 30a, 30b durch einen shallow trench bzw. einen flachen Graben, der im wesentlichen durch die zweite Bauelement-Isolierschicht 62 gebildet wird, isoliert. Dies hat den Vorteil, daß Überlapp-Kapazitäten und Ccs (Ccs = Kollektor-Substrat-Kapazitäten verringert werden. Außer dem Kollektor 36 und dem ersten Kollektorkontaktierbereich 48 grenzt kein weiteres, parasitäres Silizium an den Graben. Durch die geringeren dadurch bedingten Kapazitäten ergeben sich verringerte parasitäre Ströme, wie sie beispielsweise durch eine benachbarte Spule induziert werden können.

Das Substrat 10 weist p-dotiertes Silizium mit einer Dotierungskonzentration von 10¹³ cm⁻³ bis 10¹⁴ cm⁻³ und einen spezifischen Widerstand von 1000 Ωcm bis 100 Ωcm auf. An der Oberfläche 12 des Substrats 10 sind Unterbrechungsbereiche 90a, 90b, 90c angeordnet, welche p-dotiertes Silizium mit einer Dotierungskonzentration aufweisen, die höher ist als die der übrigen Gebiete des Substrats 10. Ein erster Unterbrechungsbereich 90a ist in Fig. 1 links am Rand der dargestellten Halbleiterstruktur angeordnet, ein zweiter Unterbrechungsbereich 90b ist zwischen den Bipolar-Transistoren 30a, 30b angeordnet, und ein dritter Unterbrechungsbereich 90c ist angrenzend an den Substratkontaktierbereich 80 angeordnet.

Über den Substratkontaktierbereich 80 und den dritten Unterbrechungsbereich 90c kann ein von Potentialen der Bipolar-Transistoren 30a, 30b unabhängiges elektrostatisches Potential an das Substrat 10 angelegt werden. Typische Potentialverhältnisse sind +5 V am Kollektor 36 und 0 V am Substrat 10. In diesem Fall bilden sich im Substrat 10 unmittelbar angrenzend an die Oberfläche 12 eine dünne Inversionsschicht 94 und daran anschließend eine wesentlich dickere Raumladungszone 96. In der Raumladungszone 96 ist die Konzentration der Majoritätsladungsträger (Löcher) gegenüber einem von der Oberfläche 12 weiter entfernten Bereich 98 des Substrats sehr stark herabgesetzt, so daß die Raumladungszone 96 eine fast verschwindende elektrische Leitfähigkeit aufweist. Die Inversionsschicht 94 wird durch eine Bewegung von Minoritätsladungsträgern, im Fall des p-Substrats Elektronen, zu der Grenzfläche zwischen Isolator und Halbleiter erzeugt. Sie weist eine endliche elektrische Leitfähigkeit auf.

Zwischen den Unterbrechungsbereichen 90a, 90b, 90c und der Inversionsschicht 94 bilden sich jeweils bzgl. der Halbleiterstruktur lateral orientierte pn-Übergänge, so daß verschiedene Bereiche der Inversionsschicht 94, welche durch Unterbrechungsbereiche 90a, 90b, 90c voneinander räumlich getrennt sind, auch elektrisch voneinander isoliert sind.

Aufgrund des beschriebenen Aufbaues der Halbleiterstruktur sind die Bipolar-Transistoren 30a, 30b voneinander nicht nur vollständig elektrisch isoliert sondern darüber hinaus auch sehr weitgehend kapazitiv entkoppelt. Einer der Gründe für die weitgehende kapazitive Entkopplung der beiden Bipolar-Transistoren 30a, 30b voneinander ist, daß ein Zwischenraum 102 zwischen denselben vollständig durch die Bauelement-Isolierschichten 60 bis 68 gefüllt ist und somit keinerlei Halbleitermaterial enthält, das nicht notwendiger Bestandteil von einem der Bipolar-Transistoren 30a, 30b ist. Somit ist gegenüber einer herkömmlichen Halbleiterstruktur mit gleicher Anordnung zweier Bipolar-Transistoren der effektive, die Größe der kapazitiven Kopplung zwischen denselben bestimmende Abstand maximal vergrößert. Kapazitäten zwischen den Bipolar-Transistoren 30a, 30b bzw. deren Komponenten sind deshalb bei gegebener räumlicher Anordnung minimal.

Eine weitere Folge des beschriebenen Aufbaus der BauelementSchicht 18 ist, wie bereits erwähnt, eine Verringerung von parasitären Strömen, die beispielsweise durch benachbarte Spulen in Halbleitermaterial induziert werden können.

Ferner weist die anhand der Fig. 1 dargestellte Halbleiterstruktur eine sehr geringe kapazitive Kopplung von jedem der Bipolar-Transistoren 30a, 30b mit dem Substrat 10 und über dieses mit dem jeweils anderen der Bipolar-Transistoren 30a, 30b auf. Gleichzeitig weist die dargestellte Halbleiterstruktur eine sehr gut wärmeleitfähige Verbindung zwischen den Bipolar-Transistoren 30a, 30b und dem Substrat 10 auf. Während in herkömmlichen Halbleiterstrukturen eine elektrostatische Isolation und eine kapazitive Entkopplung von Bauelementen in der Bauelementschicht gegenüber dem Substrat durch eine dicke Isolierschicht zwischen der Bauelementschicht und dem Substrat bewirkt wird, werden gemäß der vorliegenden Erfindung die Bipolar-Transistoren 30a, 30b oder auch andere Bauelemente in der Bauelementschicht 18 durch die Isolierschicht 14 und die Raumladungszone 96 kapazitiv vom Substrat entkoppelt. Da die kapazitive Entkopplung im wesentlichen durch die Raumladungszone 96 bewirkt wird, kann die Isolierschicht 14 so dünn ausgeführt sein, daß sie die Funktion der elektrostatischen Isolation gerade noch erfüllt. Eine Untergrenze für die Dicke der Isolierschicht 14 liegt bei ca. 3 nm. Bei einer noch dünneren Isolierschicht tritt ein Tunnelstrom auf, der eine endliche Leitfähigkeit zur Folge hat. Besonders bevorzugt liegt die Dicke der Isolierschicht 14 im Bereich von 20 nm bis etwa 100 nm, wobei die Dicke insbesondere auch alle Werte zwischen 20 nm und 100 nm annehmen kann. Weitere bevorzugte Dicken der Isolierschicht 14 liegen im Bereich bis ca. 400 nm.

Während die Isolierschicht 14 mit einer Dicke im Bereich von 3 nm bis 400 nm die Bipolar-Transistoren 30a, 30b gegenüber dem Substrat 10 elektrostatisch ausreichend isoliert, weist sie gleichzeitig eine wesentlich höhere Wärmeleitfähigkeit auf als eine Isolierschicht gemäß dem Stand der Technik. Da das Oxid der Isolierschicht 14 eine etwa um den Faktor 100 geringere Wärmeleitfähigkeit aufweist als Silizium, beeinflußt die Isolierschicht 14 wesentlich die Abfuhr von Verlustleistung bzw. von durch die Bipolar-Transistoren 30a, 30b erzeugte Wärme an das Substrat und über dieses an die Umgebung der Halbleiterstruktur. Eine wirkungsvolle Abfuhr von durch Bauelemente erzeugter Abwärme ist bei einer zunehmenden Integrationsdichte und einer zunehmend schnelleren Taktung der Bauelemente in modernen Halbleiterstrukturen von großer und weiter zunehmender Bedeutung. Die geringe Dicke der Isolierschicht 14 und die damit einhergehende hohe Wärmeleitfähigkeit derselben wird dadurch ermöglicht, daß gemäß der vorliegenden Erfindung die kapazitive Entkopplung der Bipolar-Transistoren von dem Substrat 10 durch die dicke Raumladungszone 96 bewirkt wird.

Über den Substratkontakt 80 ist es möglich, das elektrostatische Potential der Inversionszone 94 oder auch der Raumladungszone 96 im Substrat 10 unterhalb der Isolierschicht 14 festzulegen. Im Fall von niedrig p-dotiertem Material entsteht durch positive Oxidladungen bereits natürlicherweise eine Inversionsschicht unter der Isolierschicht 14. Da der erste Kollektorkontaktierbereich 48 des npn-Bipolar-Transistors 30a, 30b gegenüber dem Substrat positiv gepolt ist, wird die Bildung einer Raumladungszone unterstützt. Diese ist um so tiefer bzw. dicker je höher der spezifische Widerstand des Substrats 10 ist. Beispielsweise beträgt im Fall eines spezifischen Widerstandes des Substrats 10, genauer gesagt des Bereiches 98 außerhalb der Raumladungszone 96 von 1000 Ωcm die Dicke der Raumladungszone 96 unterhalb der Inversionsschicht 94 ca. 9 µm. Dies entspricht einer effektiven Dicke der Isolierschicht 14 von ca. 3 µm.

Die Inversionsschicht 94 an der Grenzfläche bzw. Oberfläche 12 des Substrats 10 zu der Isolierschicht 14 weist einen endlichen Schichtwiderstand auf, der in der Regel größer ist als ca. 10 kΩ/□, wie es beispielsweise dem Artikel "odeling and Measurement of Substrate Coupling in Si-Bipolar IC's up to 40 GHz" von M. Pfost et al., IEEE Journal of Solid State Circuits, Bd. 33, Nr. 4, April 1998, S. 582-591, zu entnehmen ist. Um zu vermeiden, daß die Bipolar-Transistoren 30a, 30b indirekt über die Inversionsschicht 94 kapazitiv miteinander koppeln, wird die Inversionsschicht 94 durch die Unterbrechungsbereiche bzw. Channelstops 90a, 90b, 90c unterbrochen, wobei die Unterbrechungsbereiche die Bipolar-Transistoren 30a, 30b bzw. unter denselben liegende Abschnitte 94a, 94b der Inversionsschicht 94 vorzugsweise lateral vollständig umschließen und elektrisch voneinander isolieren. Die kapazitive Kopplung der Bipolar-Transistoren 30a, 30b an die Inversionsschicht 94 hat unter dieser Bedingung keine indirekte Kopplung zwischen den Bipolar-Transistoren 30a, 30b zur Folge. Die Unterbrechungs- bzw. Isolierwirkung der Unterbrechungsbereiche 90a, 90b, 90c beruht darauf, daß diese zu der Inversionsschicht 94 jeweils zwei gegeneinander geschaltete pn-Übergänge bilden, von denen je nach Potentialdifferenz zwischen den verschiedenen Abschnitten 94ä, 94b der Inversionsschicht 94 immer einer gesperrt ist. Um diese Funktion zu erfüllen, müssen die Unterbrechungsbereiche 90a, 90b, 90c in Richtung senkrecht zu der Oberfläche 12 des Substrats 10 eine Dicke aufweisen, welche größer ist als die Dicke der Inversionsschicht 94. Da der Schichtwiderstand der Unterbrechungsbereiche 90a, 90b, 90c mit ca. 600 Ω/□ (siehe den oben genannten Artikel von M. Pfost) wesentlich geringer ist als der der Inversionsschicht 94, weisen die Unterbrechungsbereiche 90a, 90b, 90c lateral in Richtung von einem Abschnitt 94a zu dem anderen Abschnitt 94b der Inversionsschicht 94 vorzugsweise eine möglichst geringe Breite auf. Eine typische Dotierungsdichte der Unterbrechungsbereiche 90a, 90b, 90c ist 2 x 10¹⁷ cm⁻³.

Fig. 2 ist eine schematische Schnittdarstellung eines weiteren Ausführungsbeispieles einer Halbleiterstruktur gemäß der vorliegenden Erfindung. Die in Fig. 2 dargestellte Halbleiterstruktur unterscheidet sich von der in Fig. 1 dargestellten dadurch, daß das Substrat 10 einen n-dotierten Bereich 110 aufweist, der an die Oberfläche 12 des Substrats und damit an die Isolierschicht 14 und den Substratkontaktierbereich 80 angrenzt. Vorzugsweise wird an den Substratkontakt 80 und an die Kollektoren 36 der Bipolar-Transistoren 30a, 30b eine Spannung von ca. 5 V gegenüber dem Substrat 10 bzw. dem Bereich 98 des Substrats 10 angelegt. Dadurch wird der n-dotierte Bereich 110 des Substrats 10 gegenüber dem Bereich 98 des Substrats 10 gesperrt, und es bildet sich eine Raumladungszone 96 im Substrat 10. Diese Raumladungszone 96 erfüllt die gleiche Funktion wie die Raumladungszone 96 in dem anhand der Fig. 1 dargestellten Ausführungsbeispiel, nämlich die kapazitive Entkopplung der Bauelementschicht 18 bzw. der Bipolar-Transistoren 30a, 30b in der Bauelementschicht 18 von dem Substrat 10 bzw. dem Bereich 98, in dem das Substrat leitfähig ist.

Im Gegensatz zu dem anhand der Fig. 1 dargestellten Ausführungsbeispiel weist das in Fig. 2 dargestellte Ausführungsbeispiel keine Inversionsschicht 94 auf. Die N-Schicht bzw. N-Well bzw. der n-dotierte Bereich 110 ist durch Implantation einer n-Dotierung in dem ursprünglich p-dotierten Substrat gebildet. Die Implantationsdosis und damit die Dotierungsdichte in dem n-dotierten Bereich 110 ist dabei so zu wählen, daß bei der an den Substratkontaktierbereich 80 anliegenden Spannung der n-dotierte Bereich 110 vollständig ausgeräumt ist bzw. eine minimale Ladungsträgerdichte aufweist und die hochohmige Raumladungszone 96 durch den n-dotierten Bereich 110 hindurch direkt bis zu der Isolierschicht 14 reicht bzw. an diese angrenzt. Bei einer Eindringtiefe der implantierten Dotierung von 1 µm beträgt eine typische Dotierungskonzentration 10¹⁵ cm⁻³. Bei diesem Ausführungsbeispiel sind p+-dotierte Channelstops bzw. Unterbrechungsbereiche 90a, 90c nur am Rand des Chips erforderlich und vorgesehen, um die Raumladungszone 96 kontrolliert einzugrenzen bzw. ihren Rand zu definieren.

Durch Polung des durch den n-dotierten Bereich 110 und den Rest des Substrats 10 gebildeten pn-Überganges in Sperrichtung kann die Kapazität zwischen den Bipolar-Transistoren 30a, 30b und dem Substrat bzw. dessen Bereich 98 außerhalb der Raumladungszone 96 praktisch zum Verschwinden gebracht werden. Beispielsweise ist es im Fall einer 20 nm dicken Isolierschicht 14 mit einer Durchbruchsfeldstärke von 10 MV/cm und eines p-dotierten Substrates mit einem spezifischen Widerstand von 1000 Ωcm möglich, bei einer Spannung von 20 V eine Raumladungszone 96 von fast 50 µm Dicke zu erzeugen.

Für eine kapazitive Entkopplung eines Bipolar-Transistors 30a, 30b von dem Substrat 10 muß der durch den n-dotierten Bereich 110 und den Rest des Substrats 10 gebildete pn-Übergang nicht vollflächig in Sperrichtung gepolt sein, sondern es ist ausreichend, wenn dieser im Bereich und in der Nähe des Bipolar-Transistors gesperrt ist.

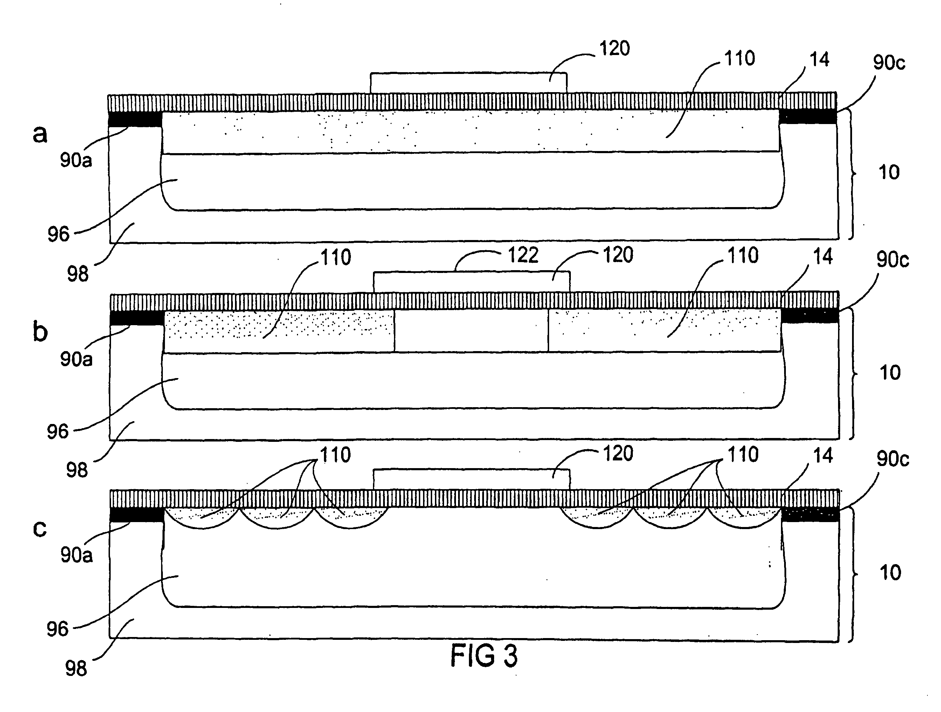

Fig. 3 ist eine schematische Schnittdarstellung von drei Varianten der Ausgestaltung bzw. der räumlichen Ausdehnung des n-dotierten Bereiches 110 im Substrat 10, wobei jeweils nur das Substrat 10 mit den Unterbrechungsbereichen 90a, 90c und dem ein- oder mehrteiligen n-dotierten Bereich 110 sowie die Isolierschicht 14 und ein Abschnitt 120 der Bauelementschicht 18 dargestellt sind. Dies entspricht einem Zustand in einer Phase während der weiter unten beschriebenen Herstellung der erfindungsgemäßen Halbleiterstruktur. Der gezeigte Abschnitt 120 der Bauelementschicht 18 stellt einen Abschnitt dar, in oder an dem Bauelemente, beispielsweise die in Fig. 1 und 2 dargestellten Bipolar-Transistoren 30a, 30b gebildet sind oder in einer späteren Phase des Herstellungsverfahrens gebildet werden.

In Fig. 3a ist der n-dotierte Bereich 110 zwischen den Unterbrechungsbereichen 90a, 90c durchgehend und weist damit die bereits in Fig. 2 dargestellte Gestalt auf. Ein dergestaltiger n-dotierter Bereich 110 wird vorzugsweise durch Implantation der n-Dotierung im Substrat 10 vor einem Aufbringen des Abschnittes 120 gebildet, wobei die Implantation ohne weiteres durch die bereits aufgebrachte dünne Isolierschicht 14 erfolgen kann.

Fig. 3b zeigt eine Variante, bei der der n-dotierte Bereich 110 erst nach dem Bilden des Abschnittes 120 auf der Isolierschicht 14 durch Implantieren erzeugt wurde. Dazu wird der Abschnitt 120 während des Implantierens der n-Dotierung durch einen nicht dargestellte Schutzschicht auf seiner von der Isolierschicht 14 abgewandten Oberfläche 122 geschützt. Die Implantierung muß dabei nicht wie in Fig. 3b dargestellt innerhalb des n-dotierten Bereiches 110 homogen erfolgen, sondern kann beispielsweise auch durch eine Gittermaske erfolgen, welche die mittlere Implantierungsdosis verringert und zu einer räumlich variablen Dotierungskonzentration bzw. einem inhomogen n-dotierten Bereich 110 führt, wie es in Fig. 3c dargestellt ist. Sofern die lateralen Abmessungen des Abschnittes 120 nicht viel größer sind als die typische Raumladungszonenweite, bildet sich durch Eindiffusion der Dotierungsatome in Randbereiche unter dem Abschnitt 120 und vor allem durch Diffusion von Ladungsträgern die dargestellte Raumladungszone 96, die sich auch in den Fig. 3b und 3c vollständig unter den Abschnitt 120 erstreckt und die anhand der Fig. 1 und 2 beschriebene Funktion erfüllt. Anders ausgedrückt müssen nicht die Diffusionsgebiete der Dotierungsatome sondern lediglich die durch alle Teile des n-dotierten Bereiches 110 erzeugten Raumladungszonen überlappen.

Eine Anwendung dieser Erkenntnis wird im folgenden beschrieben. Üblicherweise werden Implantierungsdosen größer oder gleich 1 x10¹¹ cm⁻² verwendet. Um kleinere effektive Dosen im Substrat 10 zu erhalten, ist es möglich mit einer Maske zu implantieren, deren Strukturen kleiner sind als die auftretenden Raumladungszonenweiten. Dies wird beispielsweise in dem Artikel "Variation of Lateral Doping as a Field Terminator for High Voltage Power Devices" von R. Stengl et al., IEEE Transactions on Electron. Devices Bd. 33 Nr. 3, S. 426, März 1986, beschrieben. Um beispielsweise bei einer Implantierungsdosis von 1 x 10¹¹ cm⁻² eine effektive Dosis von 5 x 10¹⁰ cm⁻² zu erhalten, würde man im einfachsten Fall durch eine Gittermaske aus Lack implantieren, welche jeweils 0,5 µm breite Öffnungen und Stege aufweist. Die Breite von 0,5 µm ist viel kleiner als die typischen Raumladungszonenweiten in einem Halbleitermaterial mit einem spezifischen Widerstand von 1000 Ω cm bei einigen Volt, so daß trotz Verwendung der Gittermaske eine weitgehend homogene Raumladungszone erzeugt würde.

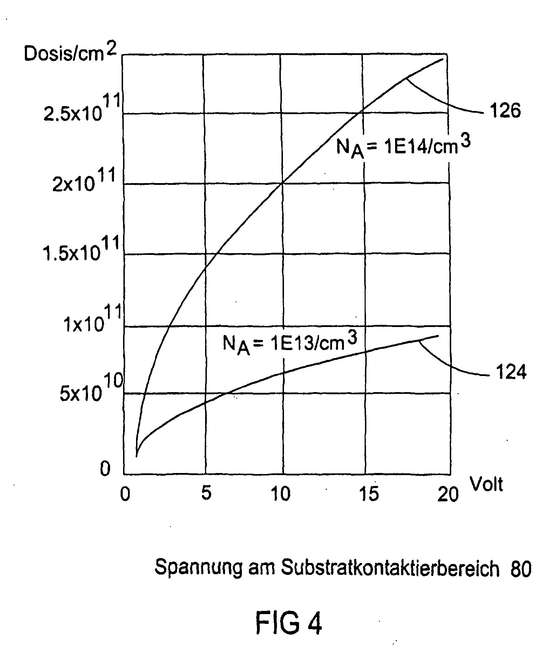

Fig. 4 ist eine schematische Darstellung eines Zusammenhanges zwischen der Spannung des Substratkontaktierbereiches 80 gegenüber dem Substrat 10 und der zur Bildung des n-dotierten Bereiches 110 in das Substrat 10 zu implantierenden Dosis unter der Randbedingung, daß die durch die Spannung erzeugte Raumladungszone 96 direkt an die Isolierschicht 14 grenzt. Dieser Zusammenhang ist für ein Substrat mit einer Grunddotierungskonzentration von 1 x 10¹³ cm⁻³ (spezifischer Widerstand ca. 1000 Ωcm; Kurve 124) und für ein Substrat mit einer Grunddotierungskonzentration von 1 x 10¹⁴ cm⁻³ (spezifischer Widerstand ca. 100 Ωcm; Kurve 126) dargestellt. Es ist zu erkennen, daß die Spannung des Substratkontaktierbereiches 80 gegenüber dem Substrat um so größer sein muß, je stärker der n-dotierte Bereich 110 dotiert ist, wenn die hochohmige Raumladungszone an die Isolierschicht 14 direkt anschließen soll. Anders ausgedrückt, je kleiner die zur Dotierung des n-dotierten Bereiches 110 verwendete Implantationsdosis ist, desto geringere Spannungen zwischen dem Substratkontaktierbereich 80 und dem Substrat 10 reichen aus, um eine Raumladungszone zu erzeugen, welche bis direkt zu der Isolierschicht 14 reicht.

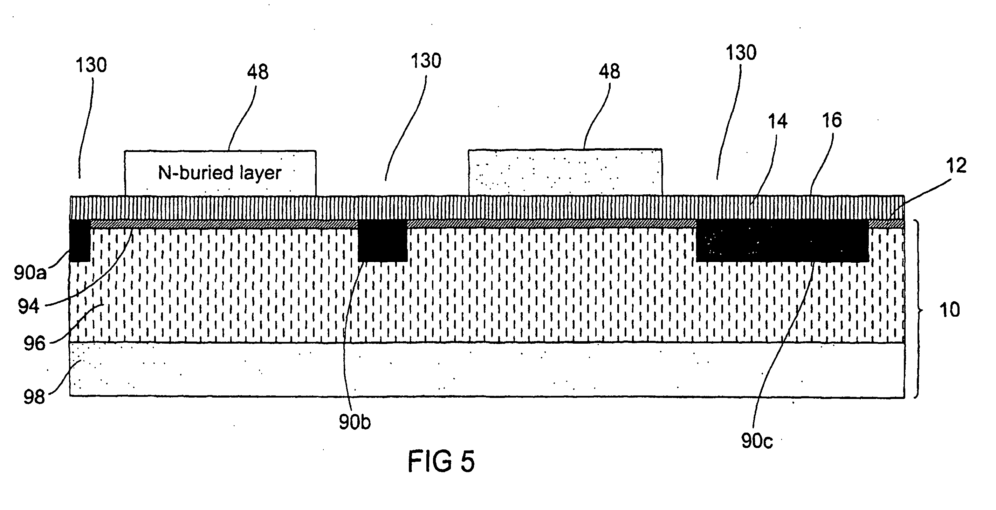

In den Fig. 5, 6 und 7 ist die in Fig. 1 dargestellte Halbleiterstruktur in verschiedenen Phasen eines Herstellungsverfahrens gemäß einem Ausführungsbeispiel der vorliegenden Erfindung dargestellt. Das dargestellte Herstellungsverfahren geht von einer SOI-Struktur aus, in der auf dem Substrat 10 die Isolierschicht 14 und darauf eine monokristalline Siliziumschicht, in der später die ersten Kollektorkontaktierbereiche 48 gebildet werden, vorliegen.

In Fig. 5 wurden in das Substrat 10 bereits die Unterbrechungsbereiche 90a, 90b, 90c eingebracht und auf der Oberfläche 12 die Isolierschicht 14 erzeugt. Auf der von dem Substrat 10 abgewandten Oberfläche 16 der Isolierschicht 14 wurde in der Siliziumschicht der SOI-Struktur eine n+-dotierte vergrabene Schicht bzw. buried layer mit einer Dicke von 600 nm und einer Dotierungskonzentration von ca. 10 x 10²⁰ cm⁻³ erzeugt, welche später die ersten Kollektorkontaktierbereiche 48 bildet. Ferner wurde in Fig. 5 die n+-dotierte vergrabene Schicht bereits durch Ätzen lateral strukturiert. Insbesondere wurden durch Ätzen von vollständigen Gräben 130, welche sich in vertikaler Richtung bzw. in Richtung senkrecht zu der Oberfläche 12 des Substrats 10 und der Oberfläche 16 der Isolierschicht 14 bis zu der Oberfläche 16 der Isolierschicht 14 erstrecken, die ersten Kollektorkontaktierbereiche 48 in ihrer lateralen Erstreckung definiert.

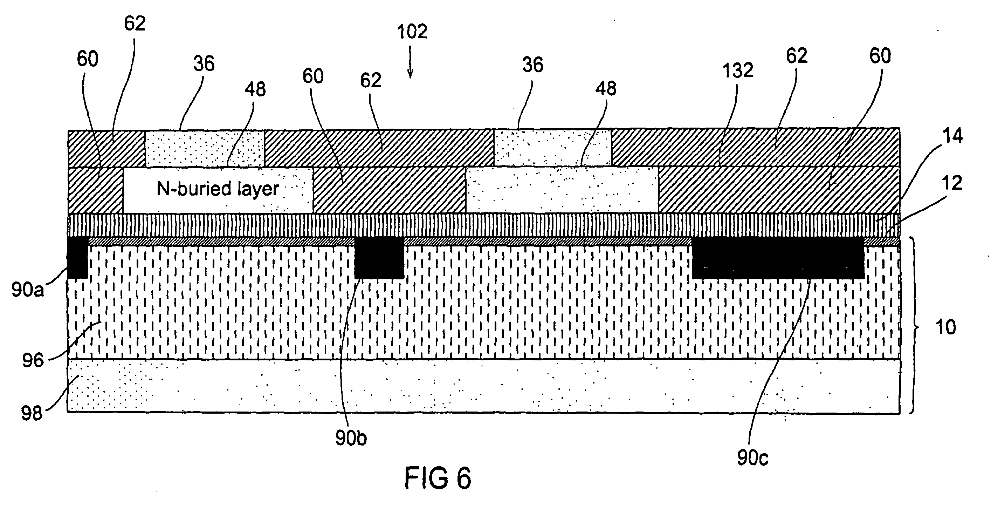

In Fig. 6 ist zu erkennen, daß in nachfolgenden Verfahrensschritten die vollständigen Gräben 130 mit einem ersten Oxid gefüllt werden. Anschließend wird durch CMP (CMP = chemischmechanisches Polieren) eine ebene Oberfläche 132 des ersten Oxids und des ersten Kollektorkontaktierbereiches 48 erzeugt. Das erste Oxid zwischen der Oberfläche 16 der Isolierschicht 14 und der Oberfläche 132 bildet die erste Bauelement-Isolierschicht 60. Anschließend wird eine zweite Oxidschicht auf der Oberfläche 132 gebildet, in der durch Photolithographie und anisotropes Ätzen Öffnungen, deren laterale Ausdehnungen denen der späteren Kollektoren 36 entsprechen, erzeugt. In diesen Öffnungen wird auf der vergrabenen Schicht bzw. den ersten Kollektorkontaktierbereichen 48 durch selektive Epitaxie Halbleitermaterial mit einer Dicke von 300 nm zur Bildung der Kollektoren 36 abgeschieden. Fig. 6 zeigt den nach diesen Verfahrensschritten hergestellten Zustand der erfindungsgemäßen Halbleiterstruktur. Der von der zweiten Bauelement-Isolierschicht 62 in dem Zwischenraum 102 zwischen den Kollektoren 36 definierten Bereich kann auch als ein mit Oxid gefüllter flacher Graben gesehen werden.

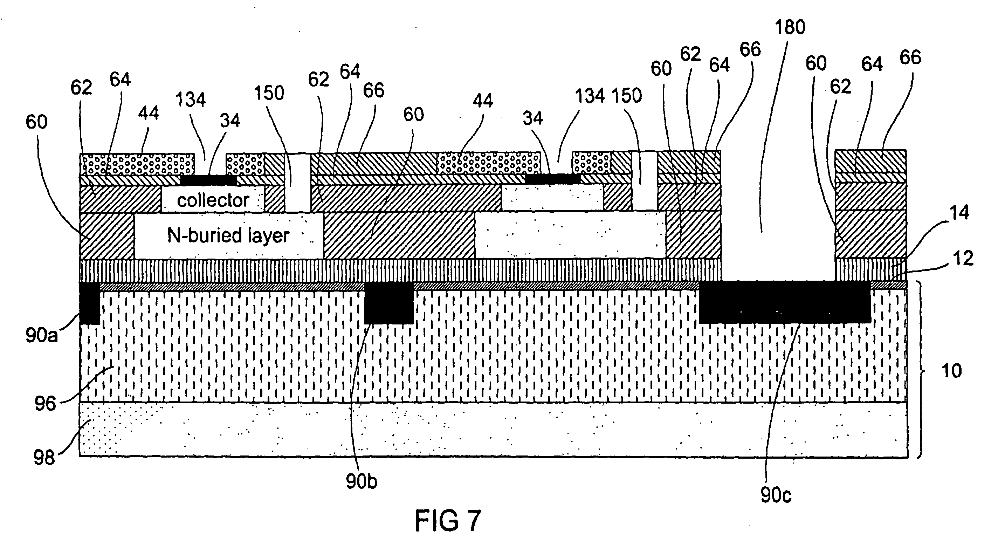

Fig. 7 zeigt einen Zustand der Halbleiterstruktur, in dem bereits die Basen 34, die dritte Bauelement-Isolierschicht 64, die ersten Basiskontaktierbereiche 44 und die vierte Bauelement-Isolierschicht 66 aufgebracht wurden. Ferner enthalten die ersten Basiskontaktierbereiche 44 je ein Loch 134, welches bis zu der Basis 34 reicht. Die zweite, dritte und vierte Bauelement-Isolierschichten 62, 64, 66 weisen Löcher 150 auf, welche bis zu den ersten Kollektorkontaktierbereichen 48 reichen. Die erste, zweite, dritte und vierte Bauelement-Isolierschichten 60, 62, 64, 66 und die Isolierschicht 14 weisen ein Loch 180 auf, welches bis zu der Oberfläche 12 des Substrats 10 bzw. zu dem an dieser Stelle unter der Oberfläche 12 liegenden Unterbrechungsbereich 90c erreicht. Die Löcher 134, 150, 180 werden in folgenden Verfahrensschritten mit monokristallinem oder polykristallinem Halbleitermaterial gefüllt, um die Emitter 32, die zweiten Kollektorkontaktierbereiche 50 und den Substratkontaktierbereich 80 zu bilden.

Der erste Basiskontaktierbereich 44 weist p+-dotiertes polykristallines Halbleitermaterial auf und stehen jeweils in Kontakt zu den p+-dotierten Basen 34. Die Basiskontaktierbereiche 44 liegen nun außer in den Nahbereichen der Basen 34 auf kapazitiv entkoppelten Gebieten mit dicker dielektrischer Isolation. Bei dem p+-dotiertem polykristallinem Halbleitermaterial handelt es sich um ein Material, das auch für passive integrierte Widerstände verwendet wird.

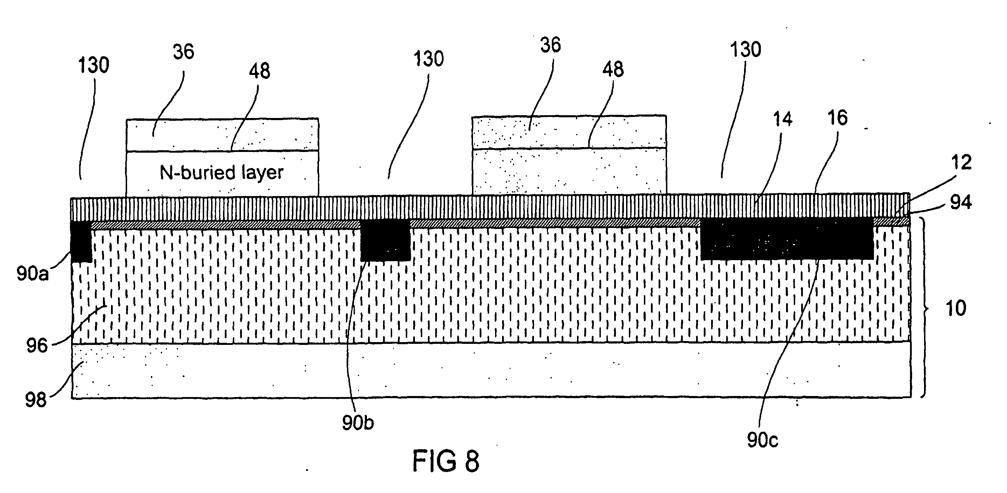

Während in den Fig. 5, 6 und 7 ein Verfahren zur Herstellung der erfindungsgemäßen Halbleiterstruktur unter Verwendung eines CMP-Schrittes und einer selektiven Epitaxie dargestellt ist, zeigen die Fig. 8, 9 und 10 verschiedene Phasen in einem Verfahren zur Herstellung der erfindungsgemäßen Halbleiterstruktur unter Verwendung einer ganzflächigen Kollektorepitaxie und zweier CMP-Schritte, wobei auch dieses Verfahren von einer SOI-Struktur ausgeht.

Fig. 8 zeigt einen Zustand der in Fig. 1 dargestellten erfindungsgemäßen Halbleiterstruktur, in dem bereits die Isolierschicht 14 und die Unterbrechungsbereiche 90a, 90b, 90c auf bzw. unter der Oberfläche 12 des Substrats 10 sowie eine Siliziumschicht auf der Oberfläche 16 der Isolierschicht 14 gebildet wurden. In die Siliziumschicht wurde ganzflächig eine n+-Dotierung eindiffundiert, um die vergrabene Schicht bzw. buried layer zu bilden, welche später die ersten Kollektorkontaktierbereiche 48 bilden wird. Anschließend wurde epitaktisch eine Siliziumschicht auf die vergrabene Schicht aufgebracht, welche später die Kollektoren 36 bilden wird. Beide Schichten wurden gemeinsam durch Photolithographie und anisotropes Ätzen strukturiert, wobei tiefe Gräben bzw. Full Trenches 130 erzeugt wurden, welche in vertikaler Richtung bis zu der Oberfläche 16 der Isolierschicht 14 reichen. Der so erzeugte Zustand ist in Fig. 8 gezeigt.

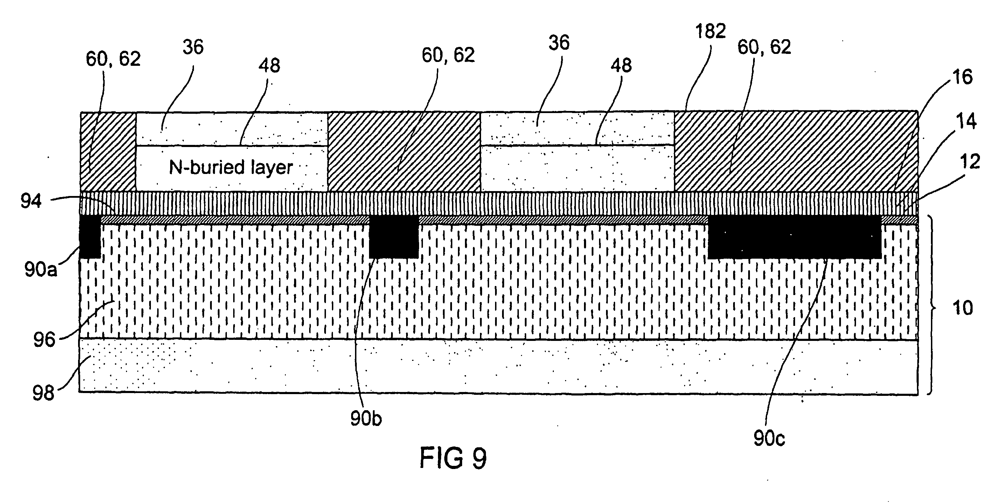

In Fig. 9 ist zu erkennen, daß die vollständigen Gräben 130 in einem nachfolgenden Verfahrensschritt mit einem Oxid gefüllt werden, welches die erste und die zweite Bauelement-Isolierschicht 60, 62 bildet. In einem CMP-Schritt wird eine ebene Oberfläche 182 der Kollektoren 36 und des Oxids gebildet.

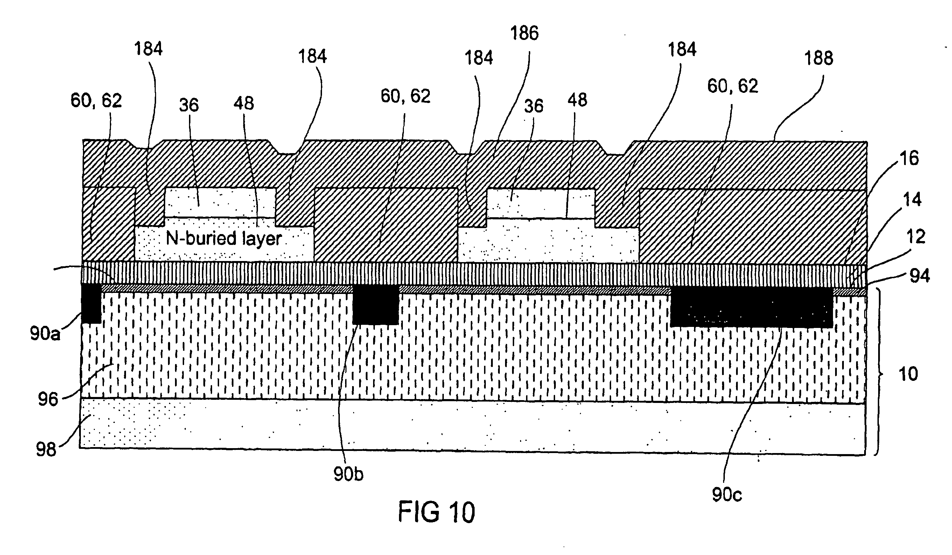

In Fig. 10 ist ein Zustand der erfindungsgemäßen Halbleiterstruktur dargestellt, in dem ausgehend von dem in Fig. 9 dargestellten Zustand Randbereiche 184 der Kollektoren 36 und der ersten Kollektorkontaktierbereiche 48 durch Ätzen strukturiert wurden, um die laterale Ausdehnung der Kollektoren 36 zu verringern. Anschließend wurde eine weitere Oxidschicht 186 aufgebracht, welche Teile der zweiten Bauelement-Isolierschicht 62 und die dritte Bauelement-Isolierschicht 64 bildet. Die Gräben 184 stellen Shallow Trenches bzw. flache Gräben dar.

Nach dem in Fig. 10 dargestellten Zustand folgt zunächst ein zweiter CMP-Schritt zur Planarisierung der von dem Substrat 10 abgewandten Oberfläche 188 der Oxidschicht 186, nachdem im wesentlichen die gleiche Struktur vorliegt, wie sie in Fig. 6 dargestellt ist.

Ein Vorteil des anhand der Fig. 8 bis 10 dargestellten Verfahrens gegenüber dem anhand der Fig. 5 bis 7 dargestellten Verfahren ist, daß Seitenwanddefekte, welche bei der selektiven Epitaxie der Kollektoren 36 entstehen können, vermieden werden. Ein Nachteil ist, daß zwei Planarisierungsschritte notwendig sind.

Besonders in den Fig. 9 und 10 ist gut zu erkennen, daß das die Bipolar-Transistoren umgebende elektrisch isolierende Material anstatt der in den Fig. 1 und 2 dargestellten Schichten auch eine andere (Schicht-)Struktur aufweisen kann, solange es den Zwischenraum 102 zwischen den Bipolar-Transistoren 30a, 30b vollständig ausfüllt.

Während in den oben dargestellten Ausführungsbeispielen Silizium als Halbleitermaterial verwendet wird, können auch andere Halbleitermaterialien verwendet werden, beispielsweise GaAs. Die Isolierschicht 14, die Emitterisolierschichten 42 und die Bauelement-Isolierschichten 60 bis 68 können das gleiche oder verschiedene elektrisch isolierende Materialien aufweisen, beispielsweise Oxide, insbesondere Siliziumoxid, oder ein Nitrid. Die erfindungsgemäße Halbleiterstruktur kann abweichend von den dargestellten Ausführungsbeispielen ferner umgekehrte Dotierungsvorzeichen aufweisen, also pnp-Bipolar-Transistoren auf einem im wesentlichen n-dotierten Substrat. In diesem Fall sind auch die Vorzeichen aller anderen Dotierungen umzukehren.

Ein wichtiger Aspekte der vorliegenden Erfindung ist, daß die Bipolar-Transistoren 30a, 30b vollständig von isolierendem Material umgeben und voneinander getrennt sind und daß kein weiteres Halbleitermaterial in dem Zwischenraum 102 zwischen den Bipolar-Transistoren 30a, 30b angeordnet ist. Diese Forderung ist jedoch einzuschränken, wenn Komponenten der beiden Bipolar-Transistoren 30a, 30b direkt über Halbleitermaterial miteinander kurzgeschlossen sind. In diesem Fall ist der Zwischenraum 102 von dem Bereich, in dem die Bipolar-Transistoren 30a, 30b miteinander kurzgeschlossen sind, abgesehen vollständig von isolierendem Material erfüllt.

Anstelle des zweiten Bipolar-Transistors 30b kann die erfindungsgemäße Halbleiterstruktur ein beliebiges weiteres aktives oder passives Halbleiter-Bauelement aufweisen. Insbesondere kann sie eine Induktivität bzw. Spule aufweisen, die ohne Einschränkungen räumlich angeordnet sein kann, da die erfindungsgemäße Halbleiterstruktur keinerlei parasitäres Halbleitermaterial aufweist, in dem durch ein magnetisches Wechselfeld Verlustleistung hervorgerufen werden könnte.

Anstelle der Isolierschicht 14 kann, wie eingangs bereits erwähnt, zwischen der Oberfläche 12 des Substrats 10 und der Bauelementschicht 18 ein pn-Übergang angeordnet sein, bzw. der Übergang bzw. die Grenzschicht zwischen dem Substrat und der Bauelementschicht als pn-Übergang ausgeführt sein. Wenn an diesen pn-Übergang eine Spannung in Sperrrichtung angelegt wird, kann der gesperrte pn-Übergang gleichzeitig die Funktion der elektrostatischen Isolation und der kapazitiven Entkopplung erfüllen.

### Bezugszeichenliste

- 10: Substrat
- 12: Oberfläche des Substrats 10
- 14: Isolierschicht
- 16: Oberfläche der Isolierschicht 14
- 18: Bauelementschicht
- 20: Oberfläche der Bauelementschicht 18
- 30a: erster Bipolar-Transistor
- 30b: zweiter Bipolar-Transistor
- 32: Emitter
- 34: Basis
- 36: Kollektor
- 42: Emitterisolierschicht
- 44: erster Basiskontaktierbereich
- 46: zweiter Basiskontaktierbereich
- 48: erster Kollektorkontaktierbereich
- 50: zweiter Kollektorkontaktierbereich
- 60: erste Bauelement-Isolierschicht
- 62: zweite Bauelement-Isolierschicht
- 64: dritte Bauelement-Isolierschicht
- 66: vierte Bauelement-Isolierschicht
- 68: fünfte Bauelement-Isolierschicht
- 80: Substratkontaktierbereich
- 90a,: 90b, 90c Unterbrechungsbereich
- 94: Inversionsschicht
- 94a,: 94b Abschnitt der Inversionsschicht 94
- 96: Raumladungszone
- 98: Bereich
- 102: Zwischenraum
- 110: n-dotierter Bereich in Substrat 10
- 120: Abschnitt
- 122: Oberfläche des Abschnittes 120
- 130: tiefer Graben
- 132: Oberfläche
- 134: Loch
- 150: Loch
- 180: Loch
- 182: Oberfläche
- 184: Graben
- 186: Oxidschicht
- 188: Oberfläche

## Patentansprüche

1. Halbleiterstruktur mit folgenden Merkmalen:
einem Substrat (10);
einer auf einer Oberfläche des Substrats (10) angeordneten Isolationsschicht (14);
einer an der von dem Substrat (10) abgewandten Oberfläche (16) der Isolationsschicht (14) angrenzenden Bauelementeschicht (18) mit einer Schichtstruktur, die eine Kollektorkontaktierschicht, eine Kollektorschicht und eine Basisschicht umfaßt;
zwei nebeneinander in der Bauelementeschicht (18) angeordneten vertikalen Bipolar-Transistoren (30a, 30b), die jeweils einen Kollektorkontaktierungsbereich (48) in der Köllektorkontaktierungsschicht, jeweils einen Kollektorbereich (36) in der Kollektorschicht, jeweils einen Basisbereich (34) in der Basisschicht und jeweils einen Emitterbereich (32) angrenzend an den Basisbereich (34) aufweisen,
wobei die Kollektorkontaktierungsschicht zwischen den Kollektorkontaktierungsbereichen (48), die Kollektorschicht zwischen den Kollektorbereichen (36) und die Basisschicht zwischen den Basisbereichen (34) der vertikalen Bipolar-Transistoren (30a, 30b) abgesehen von eventuellen Bestandteilen (50) der vertikalen Bipolar-Transistoren (30a, 30b) ausschließlich durch Isoliermaterialschichten (60, 62;' 64) gebildet sind.

2. Halbleiterstruktur nach Anspruch 1, ferner mit einem flächigen pn-Übergang, der parallel zu einer Oberfläche (12) des Substrats (10) zwischen der Oberfläche (12) des Substrats (10) und der Bauelementschicht (18) angeordnet ist,
wobei der Isolierbereich (60, 62, 64, 66, 68) an den pn-Übergang angrenzt.

3. Halbleiterstruktur nach Anspruch 1 , bei der das Substrat (10) im wesentlichen einen spezifischen Widerstand von 1000 Ω cm und die Isolierschicht (14) eine Dicke von 20 nm und eine Durchbruchsfeldstärke von 10 MVcm⁻¹ aufweisen.

4. Halbleiterstruktur nach einem der Ansprüche 1 bis 3 , bei der das Substrat (10) in dem an die Isolierschicht (14) angrenzenden Bereich einen zu der Oberfläche (12) des Substrats (10) parallel angeordneten flächigen pn-Übergang aufweist.

5. Halbleiterstruktur nach einem der Ansprüche 1 bis 4, ferner mit einem Unterbrechungsbereich (90b), der in dem an die Isolierschicht (14) angrenzenden Bereich des Substrats (10) lateral zwischen dem Bipolar-Transistor (30a) und dem Halbleiter-Bauelement (30b) angeordnet ist, den gleichen Leitfähigkeitstyp aufweist wie das Substrat (10) und eine höhere Dotierungsdichte aufweist als das Substrat (10).

6. Halbleiterstruktur nach einem der Ansprüche 1 bis 5, bei der das Substrat (10) eine an die Isolierschicht (14) angrenzende Schicht (110) aufweist, die entgegengesetzt zu einer Dotierung von anderen Bereichen des Substrats (10) dotiert ist.

7. Halbleiterstruktur nach einem der Ansprüche 1 bis 6, bei der die Isolierschicht (14) eine Dicke im Bereich von 3 nm bis 400 nm aufweist.

8. Halbleiterstruktur nach einem der Ansprüche 1 bis 7 , bei der das Substrat (10) eine Dotierungsdichte von 1 × 10¹³ cm⁻³ aufweist.

## Claims

1. Semiconductor structure, comprising:
a substrate (10);
an insulating layer (14) arranged on a surface of the substrate (10);
a device layer (18), adjoining the surface (16) of the insulating layer (14) facing away from the substrate (10), with a layer structure including a collector contacting layer, a collector layer, and a base layer;
two vertical bipolar transistors (30a, 30b) arranged next to each other in the device layer (18), comprising a collector contacting region (48) each in the collector contacting layer, a collector region (36) each in the collector layer, a base region (34) each in the base layer, and an emitter region (32) each adjoining the base region (34),
wherein the collector contacting layer between the collector contacting regions (48), the collector layer between the collector regions (36), and the base layer between the base regions (34) of the vertical bipolar transistors (30a, 30b), except for possible constituents (50) of the vertical bipolar transistors (30a, 30b), are exclusively formed by insulating material layers (60, 62; 64) .

2. Semiconductor structure of claim 1, further having a planar pn junction arranged in parallel to a surface (12) of the substrate (10) between the surface (12) of the substrate (10) and the device layer (18), with the insulating region (60, 62, 64, 66, 68) adjoining the pn junction.

3. Semiconductor structure of claim 1, wherein the substrate (10) substantially has a resistivity of 1000 Ω cm and the insulating layer (14) has a thickness of 20 nm and a breakdown field strength of 10 MVcm⁻¹.

4. Semiconductor structure of one of claims 1 to 3, wherein the substrate (10) comprises a planar pn junction arranged in parallel to the surface (12) of the substrate (10) in the region adjoining the insulating layer (14).

5. Semiconductor structure of one of claims 1 to 4, further having an interrupt region (90b) being laterally arranged in the region of the substrate (10) adjoining the insulating layer (14) between the bipolar transistor (30a) and the semiconductor device (30b), having the same conductivity type as the substrate (10), and having a higher doping density than the substrate (10).

6. Semiconductor structure of one of claims 1 to 5, wherein the substrate (10) comprises a layer (110) adjoining the insulating layer (14), doped oppositely to a doping of other regions of the substrate (10).

7. Semiconductor structure of one of claims 1 to 6, wherein the insulating layer (14) has a thickness in the range of 3 nm to 400 nm.

8. Semiconductor structure of one of claims 1 to 7, wherein the substrate (10) has a doping density of 1 x 10¹³ cm⁻³.

## Revendications

1. Structure à semi-conducteur ayant les caractéristiques suivantes :
Un substrat (10) ;
Une couche (14) isolante disposée sur une partie superficielle du substrat (10) ;
Une couche (18) à composants, contiguë à la partie (16) superficielle éloignée du substrat (10) de la couche (14) isolante, ayant une structure de couche qui comprend une couche pour l'établissement du contact du collecteur, une couche pour les collecteurs et une couche pour les bases ;
Deux transistors (30a, 30b) bipolaires verticaux disposés l'un à côté de l'autre dans la couche (18) à composants, transistors bipolaires qui présentent respectivement une zone (48) d'établissement du contact du collecteur dans la couche pour l'établissement du contact du collecteur, respectivement une zone (34) pour la base dans la couche pour les bases et respectivement une zone (32) pour l'émetteur contiguë à la zone (34) pour la base,
la couche d'établissement du contact du collecteur entre les zones (48) d'établissement du contact du collecteur, la couche pour les collecteurs entre les zones (36) pour les collecteurs et la couche pour les bases entre les zones (34) pour les bases des transistors (30a, 30b) bipolaires verticaux à l'exception de parties (50) intégrantes éventuelles des transistors (30a, 30b) bipolaires verticaux étant formées exclusivement par des couches (60, 62, 64) en matériau isolant.

2. Structure à semi-conducteur selon la revendication 1, en outre avec une jonction PN plate qui est disposée en parallèle par rapport à une partie (12) superficielle du substrat (10) entre la partie (12) superficielle du substrat (10) et la couche (18) à composants, la couche (60, 62, 64, 66, 68) isolante étant contiguë à la jonction PN.

3. Structure à semi-conducteur selon la revendication 1 pour laquelle le substrat (10) présente essentiellement une résistance spécifique de 1000 Qcm et la couche (14) isolante présente une épaisseur de 20 nm et une intensité de champ de claquage de 10 MVcm⁻¹.

4. Structure à semi-conducteur selon l'une des revendications 1 à 3 pour laquelle le substrat (10) présente une jonction PN plate disposée en parallèle par rapport à la partie (12) superficielle du substrat (10) dans la zone contiguë à la couche (14) isolante.

5. Structure à semi-conducteur selon l'une des revendications 1 à 4, en outre avec une zone (90b) d'interruption, qui est disposée latéralement entre le transistor (30a) bipolaire et la composant (30b) à semi-conducteur dans la zone contiguë à la couche (14) isolante, qui présente le même type de conductibilité que le substrat (10) et qui présente une densité de dopage plus grande que le substrat (10).

6. Structure à semi-conducteur selon l'une des revendications 1 à 5 pour laquelle le substrat (10) présente une couche (110) contiguë à la couche (14) isolante, couche (110) qui est dopée de signe opposé par rapport à un dopage des autres zones du substrat (10).

7. Structure à semi-conducteur selon l'une des revendications 1 à 6 pour laquelle la couche (14) isolante) présente une épaisseur de l'ordre de 3 nm à 400 nm.

8. Structure à semi-conducteur selon l'une des revendications 1 à 7 pour laquelle le substrat (10) présente une densité de dopage de 1 x 10¹³ cm⁻³.
